# EUROPEAN PATENT APPLICATION

(11) **EP 3 605 617 A1**
(43) Date of publication of application: **05.02.2020**
(21) Application number: 18772515.5
(22) Date of filing: 12.02.2018
(51) Int. Cl.: H01L 33/06, H01L 33/26, H01L 33/50, H01L 33/58, G02F 1/1335

(54) **QUANTUM DOT LIGHT EMITTING ELEMENT AND BACKLIGHT UNIT COMPRISING SAME**

(30) Priority: 20.03.2017 KR 20170034489
(71) Applicant: Petalux Inc., Seongnam-si, Gyeonggi-do 13438 (KR)
(72) Inventor: AHN, Do Yeol, Seoul 06720 (KR); YANG, Seung Hyun, Yongin-si Gyeonggi-do 16909 (KR)
(74) Representative: Zardi, Marco
(86) International application number: PCT/KR2018/001795
(87) International publication number: WO 2018/174409

(57) **Abstract**

The present invention relates to a quantum dot light emitting device, a light emitting device package, and a backlight unit including a quantum dot nanostructure composed of I-VII compounds. The quantum dot light emitting device included first and second electrods, a light emitting layer including the quantum dot nanostructure, a hole injection layer, a hole transport layer, an electron injection layer and an electron transport layer. The light emitting device package includes a housing, a light emitting device and a light converter, and the light emitting device is disposed in the housing. The light converter is disposed on the light emitting device, and the quantum dot nanostructure may be dispersed therein. The backlight unit includes a light source having the quantum dot light emitting device or the light emitting device package, and a light guide plate uniformly dispersing the direction of light emitted from the light source.

## Description

### [Technical Field]

The present invention relates to a semiconductor light emitting device, and more particularly, to a light emitting device capable of improving light efficiency by using quantum dots.

### [Background Art]

When the size of the semiconductor nanoparticles is smaller than the Bohr radius of the exciton formed in the semiconductor material by electrical or optical excitation, a strong quantum confinement effect is exhibited, and the semiconductor nanoparticles with that size are called quantum dot materials. A quantum well structure is a structure in which a semiconductor with relatively smaller band gap is disposed between semiconductors with relatively larger band gap. A transition energy can be adjusted by quantum confinement effect according to a thickness of the quantum well, and the transition energy is changed due to the lattice constant between the well material and the wall material.

Conventionally, quantum dots using CdSe are popularly used. In the case of CdSe quantum dots, since the bore radius is about 4.9 nm, when the diameter of the quantum dots is about 10 nm or less, the band gap energy increases due to the quantum limiting effect. In terms of the emission spectrum, red colored light (bandgap energy 1.84 eV) is emitted in the bulk state, but in the form of a quantum dot, as the size decreases, colors of shorter wavelengths such as yellow, green, and blue may be emitted. In other words, the emission color can be adjusted by controlling the size of the quantum dot.

Applying such quantum dots to the display, perfect color representation and low power consumption are possible. In addition, active research is being conducted as it can be a next-generation display product in the display market where LCD and OLED are prevalent due to the advantages of making thin and curved displays. Although the color reproducibility has been improved by more than 20-30% using quantum dot display (QD-LED), the light efficiency compared to high manufacturing cost is not meeting expectations. That is, wavelength varies depending on the size of the nanoparticles of the quantum dots, but there is a limit in reducing the size of the quantum dot nanoparticles.

### [Detailed Description of the Invention]

### [Objects of the Invention]

Accordingly, the problem to be solved by the present invention is to improve the light efficiency of the light emitting device using the I-VII quantum dot nanostructure.

### [Technical Solution]

A quantum dot light emitting device according to the present invention for solving the above problem may comprise a first electrode, a second electrode, a light emitting layer, a hole injection layer, a hole transport layer, an electron injection layer and an electron transport layer. The second electrode may be disposed over the first electrode. The light emitting layer may be disposed between the first electrode and the second electrode and include a quantum dot nanostructure. The hole injection layer may be disposed between the first electrode and the light emitting layer. The hole transport layer may be disposed between the hole injection layer and the light emitting layer. The hole transport layer lowers difference of potential barrier between the light emitting layer and the hole injection layer. The electron injection layer may be positioned between the light emitting layer and the second electrode to move electrons from the second electrode to the light emitting layer. The electron transport layer may be disposed between the electron injection layer and the light emitting layer and transfers electrons from the electron injection layer to the light emitting layer. The quantum dot nanostructure may include a core layer and a shell layer surrounding the core layer, and one or both of the core layer and the shell layer may include an I-VII compound composed of copper group and halogen group.

A light emitting device package according to the present invention may comprise a housing, a light emitting device and a light converter. The light emitting device may be disposed inside the housing. The light converter may be disposed on the light emitting device and in which a quantum dot nanostructure is dispersed. The quantum dot nanostructure may include a core layer and a shell layer surrounding the core layer, and one or both of the core layer and the shell layer may include an I-VII compound composed of copper group and halogen group.

The I-VII compound may include one of CuCl, CuBr, Cul, AgBr, AgI, CuF, AgF, AgCl, AuF, AuCl, AuBr, AuI, CuFCl, CuBrF, CuFI, CuClBr, CuClI, CuBrI, AgFCl, AgFBr, AgFI, AgClBr, AgClI, AgBrI, AuFCl, AuFBr, AuFI, AuClBr, AuClI, AuBrI, CuF-ClBr, CuFClI, CuFBrI, CuIBrCl, AgFClBr, AgFClI, AgFBrI, AgClBrI, AuFClBr, AuFClI, and AuClBrI, or a combination thereof.

The I-VII compound may have the same copper group element, and an atomic number of the core layer may be higher than that of the shell layer in the halogen element.

The quantum dot nanostructure may be 1nm to 20nm in diameter.

The light emitting layer may further comprise any one or a mixture of two or more phosphors and fluorescent materials.

The light emitting device may emit light with a blue wavelength, and the light converter may absorb light of a yellow or green wavelength to emit light of a white or daylight color wavelength.

A backlight unt according to the present invention may comprise a light source having a quantum dot light emitting device according to the present invention, or a light emitting device according to the present invention, and a light guide plate uniformly dispersing the direction of light emitted from the light source.

### [Advantageous Effects]

According to the present invention, the luminous efficiency may be improved due to the quantum dot nanostructure by the I-VII compound, and in particular, the luminous efficiency may be excellent in the short wavelength region (300 nm to 500 nm).

In addition, the emission wavelength region may be adjusted by modifying the size of the quantum dot nanostructure.

In addition, the quantum dot nanostructure light emitting device can be applied to the flexible display to reduce the cost compared to the display using the organic material.

In addition, the quantum dot nanostructure of the I-VII compound may be utilized as a semiconductor, and further may have excellent electrical properties.

### [Description of the Drawings]

FIG. 1 illustrates a quantum dot light emitting device according to an exemplary embodiment of the present invention.
FIG. 2 is a cross-sectional view of a quantum dot nanostructure according to an exemplary embodiment of the present invention.
FIG. 3 is a cross-sectional view of a light emitting device package according to an exemplary embodiment of the present invention.
FIG. 4 is a cross-sectional view of a light emitting device package according to another exemplary embodiment of the present invention.
FIG. 5 and FIG. 6 are graphs comparing the light emission characteristics of the quantum dot light emitting devices according to the examples and comparative examples of the present invention.

### [Mode for Invention]

As the inventive concept allows for various changes and numerous embodiments, particular embodiments will be illustrated in the drawings and described in detail in the text. However, this is not intended to limit the present invention to the specific disclosed form, it should be understood to include all modifications, equivalents, and substitutes included in the spirit and scope of the present invention. In describing the drawings, similar reference numerals are used for similar components. In the accompanying drawings, the dimensions of the structures may be exaggerated than actual for clarity of the invention.

Terms such as first and second may be used to describe various components, but the components should not be limited by the terms. The terms are used only for the purpose of distinguishing one component from another. For example, without departing from the scope of the present invention, the first component may be referred to as the second component, and similarly, the second component may also be referred to as the first component.

The terminology used herein is for the purpose of describing particular embodiments only and is not intended to be limiting of the invention. Singular expressions include plural expressions unless the context clearly indicates otherwise. In this application, the terms "comprise" or "having" are intended to indicate that there is a feature, number, step, action, component, part, or combination thereof described in the specification, and should be understood that it does not exclude the possibility of the presence or addition of features, numbers, steps, actions, componets, parts or combination thereof. In addition, A and B are 'connected' and 'coupled' means that in addition to A and B being directly connected or combined, another component C may be included between A and B so that A and B are connected or combined.

Unless defined otherwise, all terms used herein, including technical or scientific terms, have the same meaning as commonly understood by one of ordinary skill in the art. Terms such as those defined in the commonly used dictionaries should be construed as having meanings consistent with the meanings in the context of the related art, and are not construed in ideal or excessively formal meanings unless expressly defined in this application. In addition, in the claims for the method invention, the steps may be reversed in order unless the steps are explicitly bound in order.

Hereinafter, exemplary embodiments of the present invention will be described in detail with reference to the accompanying drawings.

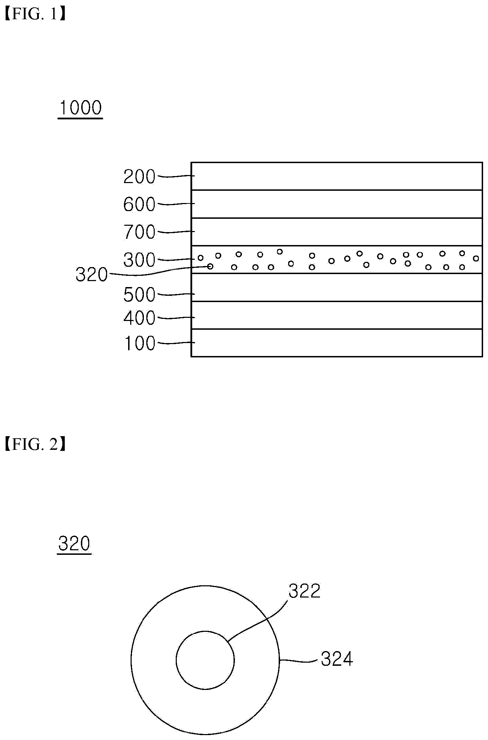

FIG. 1 illustrates a quantum dot light emitting device 1000 according to the present invention, and FIG. 2 is a cross-sectional view of the quantum dot nanostructure 320.

Referring to FIG. 1, the quantum dot light emitting device 1000 may include a first electrode 100, a second electrode 200, a light emitting layer 300, a hole injection layer 400, a hole transport layer 500, and an electron injection layer 600 and an electron transport layer 700. The second electrode 200 may be disposed above the first electrode 100, and the light emitting layer 300 may be disposed between the first electrode 100 and the second electrode 200. The light emitting layer 300 may include a quantum dot nanostructure 320. In addition, the hole injection layer 400 may be disposed between the first electrode 100 and the light emitting layer 300. In addition, the hole transport layer 500 may be disposed between the hole injection layer 400 and the light emitting layer 300 to lower the potential barrier between the light emitting layer 300 and the hole injection layer 400. In addition, the electron injection layer 600 may be located between the light emitting layer 300 and the second electrode 200, and may move electrons from the second electrode 200 to the light emitting layer 300. In addition, the electron transport layer 700 may be disposed between the electron injection layer 600 and the light emitting layer 300, and may transfer electrons from the electron injection layer 600 to the light emitting layer 300. In addition, the quantum dot nanostructure 320 may include a core layer 322 and a shell layer 324 surrounding the core layer 322, as shown in FIG. 2. One or both of the core layer 322 and the shell layer 324 may comprise a I-VII compound composed of copper group and halogen group. The color may be adjusted differently according to the size of the core layer 322, and the shell layer 324 surrounding the core layer 322 may serve to improve light emission characteristics.

In addition, the I-VII compound may include one of CuCl, CuBr, CuI, AgBr, AgI, CuF, AgF, AgCl, AuF, AuCl, AuBr, AuI, CuFCl, CuBrF, CuFI, CuClBr, CuClI, CuBrI, AgFCl, AgFBr, AgFI, AgClBr, AgClI, AgBrI, AuFCl, AuFBr, AuFI, AuClBr, AuClI, AuBrI, CuF-ClBr, CuFClI, CuFBrI, CuIBrCl, AgFClBr, AgFClI, AgFBrI, AgClBrI, AuFClBr, AuFClI, and AuClBrI, or a combination thereof.

In addition, the I-VII compound has the same copper group element, and an atomic number of the core layer 322 may be higher than that of the shell layer 324 in the halogen element. In other words, the bandgap energy of the core layer 322 may be greater than the bandgap energy of the shell layer 324. For example, the structure of the core layer 322 / shell layer 324 can be made of the structure of CuCl / CuBr or CuCl / CuI. Accordingly, electrons and holes may be relatively located in the shell layer 324, and the emission wavelength may be adjusted according to the thickness of the shell layer 324. In addition, the shell layer 324 may further increase the quantum efficiency of the core layer 322. In addition, one or both of the core layer 322 and the shell layer 324 may be formed in multiple layers to change the efficiency of the quantum dot.

In addition, the quantum dot nanostructure 320 may have a diameter of 1nm to 20nm. Since the quantum dot nanostructure 320 may emit a specific light below a bore radius, when the quantum dot nanostructure 320 is larger than 20 nm, quantum effects are not actively generated. On the other hand, if it is smaller than the bore radius, a light with a specific wavelength is emitted, and as it becomes smaller, the wavelength becomes shorter from red to blue light. However, if the radius is less than 1nm, it is difficult to disperse.

In addition, the light emitting layer 300 may further include one or a mixture of two or more phosphors and fluorescent materials. White light can be generated by mixing light of different wavelength, and lights with various wavelength can be generated to improve color reproducibility.

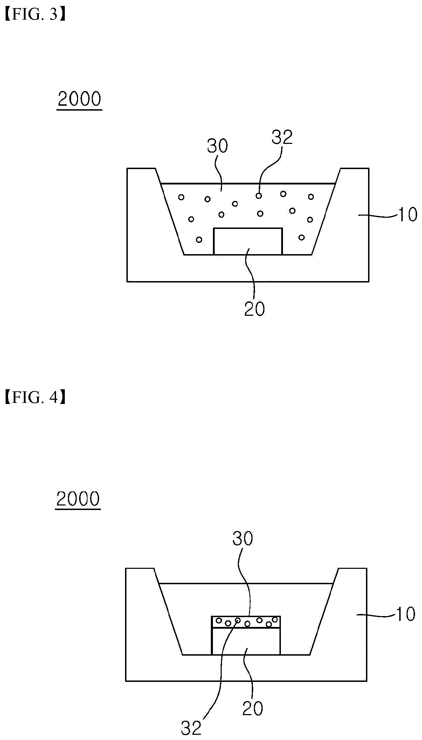

FIG. 3 and FIG. 4 illustrate a light emitting device package 2000 according to exemplary embodiments of the present invention.

Referring to FIG. 3 and FIG. 4, the light emitting device package 2000 according to the present invention may include a housing 10, a light emitting device 20, and a light converter 30. The light emitting device 20 may be disposed in the housing 10. In addition, the light converter 30 may be disposed above the light emitting device 10, and the quantum dot nanostructure 32 may be dispersed in the light converter 30.

In this case, as shown in FIG. 3, the light converter 30 may be disposed and molded between the housing 10 and the light emitting device 20. Light emitted from the light emitting device 20 may be converted by the quantum dot nanostructure 32 before exiting to the outside of the housing 10.

Alternatively, as shown in FIG. 4, the light converter 30 may be stacked on the light emitting device 20. Loss of light generated from the light emitting device 20 can be minimized.

In addition, the quantum dot nanostructure 32 may include a core layer 322 and a shell layer 324 surrounding the core layer 322, and one or both of the core layer 322 and the shell layer 324 may comprise a I-VII compound composed of copper group and halogen group.

In addition, the I-VII compound may include one of CuCl, CuBr, CuI, AgBr, AgI, CuF, AgF, AgCl, AuF, AuCl, AuBr, AuI, CuFCl, CuBrF, CuFI, CuClBr, CuClI, CuBrI, AgFCl, AgFBr, AgFI, AgClBr, AgClI, AgBrI, AuFCl, AuFBr, AuFI, AuClBr, AuClI, AuBrI, CuF-ClBr, CuFClI, CuFBrI, CuIBrCl, AgFClBr, AgFClI, AgFBrI, AgClBrI, AuFClBr, AuFClI, and AuClBrI, or a combination thereof.

In addition, the I-VII compound has the same copper group element, and an atomic number of the core layer may be higher than that of the shell layer in the halogen element.

In addition, the quantum dot nanostructure 32 may be 1 nm to 20 nm in diameter. This is to maximize the easy dispersion and luminous efficiency of the quantum dot nanostructure 31 as described above.

In addition, the light converter 30 may further include any one or a mixture of two or more phosphors and fluorescent materials.

In addition, the light emitting device 20 may emit light having a blue wavelength, and the light converter 30 may absorb light having a yellow or green wavelength so as to emit light having a white or daylight color wavelength. The white light generated in this way may be applied to the display backlight unit to maximize luminous efficiency and increase color clarity.

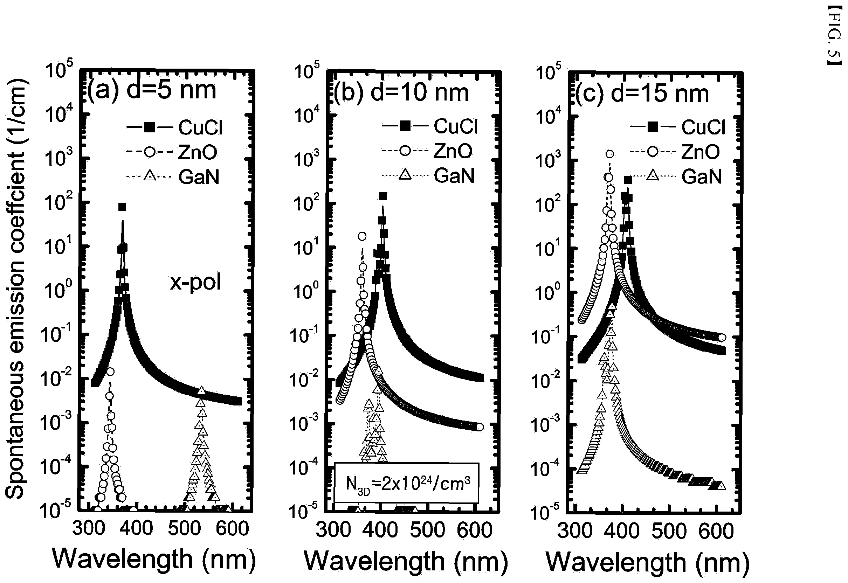

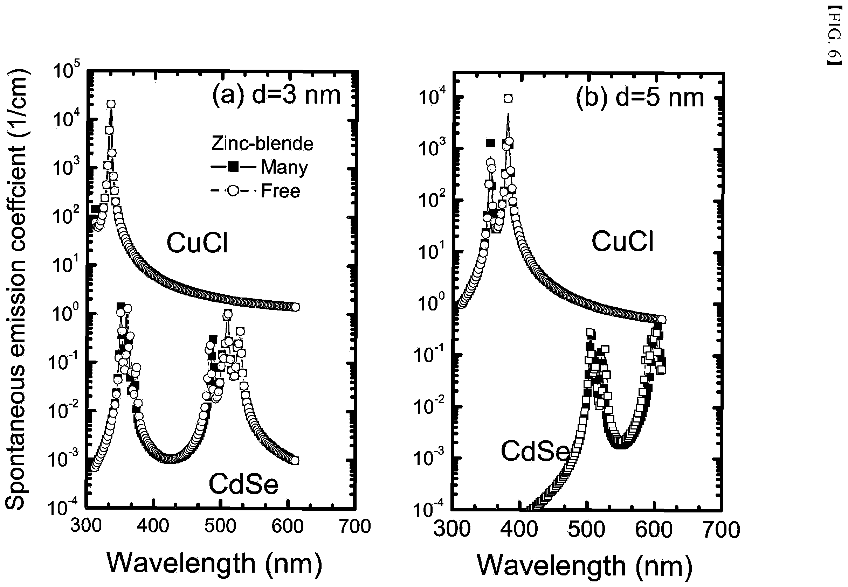

FIG. 5 and FIG. 6 are graphs measuring light emission characteristics of light emitting device packages according to embodiments and comparative examples of the present invention.

In FIG. 5, quantum dots of CuCl, ZnO, and GaN were made to have diameters of 5 nm, 10 nm, and 15 nm, and the emission efficiency was measured for each wavelength. As the diameter of the I-VII compound CuCl quantum dot according to an exemplary embodiment of the present invention decreases, the wavelength showing the highest light efficiency is shifted to a shorter region. In addition, it can be seen that the light efficiency of the CuCl quantum dot at 5nm is significantly superior to other ZnO and GaN quantum dots. On the other hand, ZnO quantum dots, as the size becomes smaller, shows light emission characteristics of a shorter wavelength range, but the light efficiency drops rapidly. In addition, the GaN quantum dot shows the lowest optical efficiency among the three quantum dots, and when the size is 5nm it was confirmed that the optical properties are moved to a higher wavelength rather. It is expected that as the size becomes smaller, the dispersion stability becomes poor and aggregated.

FIG. 6 illustrates a CuCl quantum dot nanostructure as an exemplary embodiment according to the present invention, and a CdSe quantum dot nanostructure as a comparative example. At this time, the luminescent properties according to the presence or absence and crystallization of the zinc-blende crystal structure is compared. When the diameter of the two quantum dots is 3nm, CuCl has the highest light efficiency in the short wavelength of 300nm band, and CdSe shows the high luminescence properties at 350nm and 500nm. In addition, it can be seen that the optical efficiency of the CuCl quantum dot nanostructure is significantly higher than that of CdSe. On the other hand, there was no significant change in the presence or absence of the zinc-blende crystal structure. In addition, when the CuCl and CdSe quantum dot nanostructure diameter is 5nm, it can be seen that the light emitting region of CdSe is pushed out by about 100nm to 200nm. On the other hand, CuCl showed only 20nm ∼ 40nm difference. In addition, it can be seen that the light efficiency of the CuCl quantum dot nanoparticles according to the present invention is remarkably high, and the zinc-blende crystal structure has less influence on the main wavelength region.

Therefore, the quantum dot nanostructure made of the I-VII compound has excellent light emission characteristics, and when applied to the light emitting device and the light emitting device package, the light efficiency can be improved.

A backlight unit according to the present invention includes a light source having the quantum dot light emitting device 1000 according to any one of claim 1 to 5, or the light emitting device package 2000 according to any one of items 6 to 11, and a light guide plate uniformly dispersing the direction of light emitted from the light source. The light source may be economical due to its long life due to light emission by the quantum dot nanostructures 320 and 32. In addition, since the luminous efficiency is high, power consumption can be reduced.

Although the present invention has been described in the detailed description of the invention with reference to exemplary embodiments of the present invention, it will be understood to those skilled in the art that various modifications and variation can be made in the present invention without departing from the spirit or scope of the invention.

## Claims

1. A quantum dot light emitting device comprising:
a first electrode;
a second electrode disposed over the first electrode;
a light emitting layer disposed between the first electrode and the second electrode and including a quantum dot nanostructure;
a hole injection layer disposed between the first electrode and the light emitting layer;
a hole transport layer disposed between the hole injection layer and the light emitting layer, the hole transport layer lowering difference of potential barrier between the light emitting layer and the hole injection layer;
an electron injection layer positioned between the light emitting layer and the second electrode to move electrons from the second electrode to the light emitting layer; and
an electron transport layer disposed between the electron injection layer and the light emitting layer and transferring electrons from the electron injection layer to the light emitting layer;
wherein the quantum dot nanostructure includes a core layer and a shell layer surrounding the core layer, and one or both of the core layer and the shell layer include an I-VII compound composed of copper group and halogen group.

2. The quantum dot light emitting device of claim 1, wherein the I-VII compound may include one of CuCl, CuBr, CuI, AgBr, AgI, CuF, AgF, AgCl, AuF, AuCl, AuBr, AuI, CuFCl, CuBrF, CuFI, CuClBr, CuClI, CuBrI, AgFCl, AgFBr, AgFI, AgClBr, AgClI, AgBrI, AuFCl, AuFBr, AuFI, AuClBr, AuClI, AuBrI, CuF-ClBr, CuFClI, CuFBrI, CuIBrCl, AgFClBr, AgFClI, AgFBrI, AgClBrI, AuFClBr, AuFClI, and AuClBrI, or a combination thereof.

3. The quantum dot light emitting device of claim 2, wherein the I-VII compound has the same copper group element, and an atomic number of the core layer is higher than that of the shell layer in the halogen element.

4. The quantum dot light emitting device of claim 1, wherein the quantum dot nanostructure is 1nm to 20nm in diameter.

5. The quantum dot light emitting device of claim 1, wherein the light emitting layer further comprises any one or a mixture of two or more phosphors and fluorescent materials.

6. A light emitting device package comprising:
a housing;
a light emitting device disposed inside the housing; and
a light converter disposed on the light emitting device and in which a quantum dot nanostructure is dispersed;
wherein the quantum dot nanostructure includes a core layer and a shell layer surrounding the core layer, and one or both of the core layer and the shell layer include an I-VII compound composed of copper group and halogen group.

7. The light emitting device package of claim 6, wherein the I-VII compound may include one of CuCl, CuBr, CuI, AgBr, AgI, CuF, AgF, AgCl, AuF, AuCl, AuBr, AuI, CuFCl, CuBrF, CuFI, CuClBr, CuClI, CuBrI, AgFCl, AgFBr, AgFI, AgClBr, AgClI, AgBrI, AuFCl, AuFBr, AuFI, AuClBr, AuClI, AuBrI, CuF-ClBr, CuFClI, CuFBrI, CuIBrCl, AgFClBr, AgFClI, AgFBrI, AgClBrI, AuFClBr, AuFClI, and AuClBrI, or a combination thereof.

8. The light emitting device package of claim 7, wherein the I-VII compound has the same copper group element, and an atomic number of the core layer is higher than that of the shell layer in the halogen element.

9. The light emitting device package of claim 6, wherein the quantum dot nanostructure is 1nm to 20nm in diameter.

10. The light emitting device package of claim 6, wherein the light emitting layer further comprises any one or a mixture of two or more phosphors and fluorescent materials.

11. The light emitting device package of claim 6, wherein the light emitting device emits light with a blue wavelength, and the light converter absorbs light of a yellow or green wavelength to emit light of a white or daylight color wavelength.

12. A backlight unit comprising:
a light source having a quantum dot light emitting device according to one of claim 1 to claim 5, or a light emitting device according to claim 6 to claim 11; and
a light guide plate uniformly dispersing the direction of light emitted from the light source.
